# EUROPÄISCHE PATENTANMELDUNG

(11) **EP 4 589 231 A1**
(43) Veröffentlichungstag der Anmeldung: **23.07.2025**
(21) Anmeldenummer: 24219821.6
(22) Anmeldetag: 13.12.2024
(51) Int. Cl.: F25D 29/00, F25D 31/00, F25D 23/02, F25D 23/06, F25D 25/02, G01B 11/02, H03K 17/94, H03K 17/968

(54) **HAUSHALTGERÄT UND VERFAHREN ZUM AKTIVIEREN UND/ODER DEAKTIVIEREN EINER GERÄTEFUNKTION EINES HAUSHALTGERÄTES**

(30) Priorität: 17.01.2024 DE 102024101245
(71) Anmelder: Miele & Cie. KG, 33332 Gütersloh (DE)
(72) Erfinder: Carsten, Daniel, 33615 Bielefeld (DE)

(57) **Zusammenfassung**

Die Erfindung betrifft ein Haushaltgerät (100), das einen Gerätekorpus (105), der einen Innenraum (110) zum Aufnehmen von Aufbewahrungsgut ausformt, eine zumindest teilweise transparente Gerätetür (120) zum Öffnen und Verschließen des Innenraums (110), wobei die Gerätetür (120) eine dem Inneren des Gerätekorpus (105) zugewandte Innenfläche (205) und eine der Innenfläche (205) abgewandte Außenfläche (210) aufweist, und eine Sensoreinheit (125) mit mindestens einem auf einen transparenten Abschnitt der Innenfläche (205) der Gerätetür (120) gerichteten Erfassungssensor (130) zum Erfassen einer Benutzerinteraktion eines Nutzers auf der Außenfläche (210) der Gerätetür (120) aufweist, um eine Gerätefunktion des Haushaltgerätes (100) zu aktivieren und/oder zu deaktivieren, wobei die Sensoreinheit (125) im Innenraum (110) angeordnet ist.

## Beschreibung

Haushaltgerät und Verfahren zum Aktivieren und/oder Deaktivieren einer Gerätefunktion eines Haushaltgerätes

Die Erfindung betrifft ein Haushaltgerät und ein Verfahren zum Aktivieren und/oder Deaktivieren einer Gerätefunktion eines Haushaltgerätes.

Haushaltgeräte können für eine Vielzahl von unterschiedlichen Bereichen innerhalb eines Haushalts eingesetzt werden. Haushaltgeräte weisen oftmals im Zusammenhang mit einem Smarthome elektrische Komponenten, beispielsweise Sensoren auf. So gibt es bereits Komponenten für das Optical Sensing, die für eine Benutzerinteraktion hinter einer Blende gedacht sind. Diese Komponenten werden direkt hinter der Oberfläche gesetzt und detektieren eine Berührung des Nutzers.

Zur Erkennung von Touchgesten auf Oberflächen werden für gewöhnlich kapazitive Sensorlösungen verwendet. Dies können einzelne Tasten, oder ganze Touchoberflächen durch Touchfolien, beispielsweise vor einem Display, sein. Des Weiteren gibt es Sensorlösungen, die direkt hinter einer Oberfläche angebracht werden, um durch Druckmessung eine Touchgeste auf einer metallischen Oberfläche zu detektieren und bei der eine kapazitive Sensorlösung nicht eingesetzt werden kann. Die Druckmessung ist dabei üblicherweise entweder in 1D durch einen Sensor direkt hinter dem Bedienelement realisiert oder in 2D, um auch eine laterale Auflösung ähnlich zu einer Touchfolie zu realisieren. Dafür benötigte Komponenten werden üblicherweise direkt hinter diejenige Oberfläche gesetzt, mit der der Nutzer interagieren soll.

Der hier vorgestellte Ansatz stellt sich die Aufgabe, ein verbessertes Haushaltgerät und ein verbessertes Verfahren zum Aktivieren und/oder Deaktivieren einer Gerätefunktion eines Haushaltgerätes zu schaffen.

Erfindungsgemäß wird diese Aufgabe durch ein Haushaltgerät und ein Verfahren zum Aktivieren und/oder Deaktivieren einer Gerätefunktion eines Haushaltgerätes mit den Merkmalen der Hauptansprüche gelöst. Vorteilhafte Ausgestaltungen und Weiterbildungen der Erfindung ergeben sich aus den nachfolgenden Unteransprüchen.

Durch den vorgestellten Ansatz kann eine Möglichkeit geschaffen werden, um vorteilhafterweise eine transparente Geräteoberfläche zur Benutzerinteraktion nutzbar machen. Vorteilhafterweise können zudem Herstellungskosten reduziert werden.

Es wird ein Haushaltgerät vorgestellt, das einen Gerätekorpus, der einen Innenraum zum Aufnehmen von Aufbewahrungsgut ausformt, eine zumindest teilweise transparente Gerätetür zum Öffnen und Verschließen des Innenraums, wobei die Gerätetür eine dem Inneren des Gerätekorpus zugewandte Innenfläche und eine der Innenfläche abgewandte Außenfläche aufweist, und eine Sensoreinheit mit mindestens einem auf einen transparenten Abschnitt der Innenfläche der Gerätetür gerichteten Erfassungssensor zum Erfassen einer Benutzerinteraktion eines Nutzers auf der Außenfläche der Gerätetür aufweist, um eine Gerätefunktion des Haushaltgerätes zu aktivieren und zusätzlich oder alternativ zu deaktivieren. Dabei ist die Sensoreinheit im Innenraum angeordnet.

Das Haushaltgerät kann dabei beispielsweise als ein Kühlgerät oder als ein Aufbewahrungsgerät ausgeformt sein. Beispielsweise kann das Haushaltgerät als ein Weinschrank ausgeführt sein, bei dem eine gewünschte Temperatur konstant gehalten werden kann. Das Haushaltgerät weist dazu den Gerätekorpus aufweisen. Der Gerätekorpus kann beispielsweise unterschiedlich groß ausgestaltet sein und optional eine Vielzahl von Einlegeböden oder Einlegeebenen zum Einlegen von beispielsweise Weinflaschen in den Innenraum aufweisen. Der Weinschrank kann dabei vorteilhafterweise einer Vitrine ähnlich eine durchsichtige Gerätetür aufweisen, die beispielsweise als eine Schwenktür ausgeführt sein kann. Vorteilhafterweise kann dadurch eine Einschränkung eines Sichtbereichs für einen Nutzer vermieden werden. Die Sensoreinheit kann vorteilhafterweise in dem Innenraum und beispielsweise in einen der Einlegeböden integriert sein, sodass eine Verkabelung der Sensoreinheit für einen Nutzer nicht sichtbar ist. Die Benutzerinteraktion kann beispielsweise eine Berührung der Außenfläche der Gerätetür sein. Da der Erfassungssensor im Innenraum angeordnet ist, kann dieser die Benutzerinteraktion berührungslos erfassen.

Gemäß einer Ausführungsform kann die Sensoreinheit beabstandet zu der Innenfläche der Gerätetür angeordnet sein, insbesondere mit einem Abstand von 3 bis 10cm. Der Abstand zwischen der Sensoreinheit und der Innenfläche kann vorteilhafterweise als Sollabstand vorgegeben sein, sodass beispielsweise bei einer Differenz zwischen dem Soll-Abstand und einem Ist-Abstand auf die Benutzerinteraktion rückgeschlossen werden kann. Durch den räumlichen Abstand der Sensoreinheit zu der Gerätetür können auftretende Kosten reduziert werden.

Ferner kann der Erfassungssensor ausgebildet sein, um die Benutzerinteraktion unter Verwendung einer Reflektionsmessung und zusätzlich oder alternativ unter Verwendung einer optischen Abstandsmessung erfassen zu können. Bei der Reflektionsmessung kann vorteilhafterweise an der Innenfläche zurückgeworfenes Licht ausgewertet werden. Wenn beispielsweise eine Lichtintensität des reflektierten Lichts größer ist als ein vorgegebener Schwellenwert, wie beispielsweise 50 Prozent, kann daraus geschlossen werden, dass ein lichtundurchlässiges Objekt oder beispielsweise eine Hand des Nutzers die Außenfläche berührt und das Licht dort reflektiert wird. Wenn die Lichtintensität des reflektierten Lichts dagegen kleiner oder gleich ist wie dieser Schwellenwert, kann daraus geschlossen werden, dass die Außenfläche nicht berührt wird oder wurde. Zusätzlich oder alternativ kann vorteilhafterweise die optische Abstandsmessung erfolgen. Beispielsweise kann die Gerätetür durch Drücken verformt werden, sodass selbst Abstandsveränderungen im Mikrometerbereich erfasst werden können. Solche Abstandsveränderungen können vorteilhafterweise als Benutzerinteraktion interpretiert werden, sodass die Gerätefunktion aktiviert oder deaktiviert werden kann. Die Abstandsmessung kann beispielsweise unter Verwendung eines Time-of-Flight- Sensors oder mittels eines Interferenzverfahrens erfolgen.

Gemäß einer Ausführungsform kann der Erfassungssensor als ein optischer Sensor ausgeformt sein und zusätzlich oder alternativ zumindest eine Lichtquelle aufweisen. Die Lichtquelle kann vorteilhafterweise als eine lichtemittierende Diode (Leuchtdiode), als eine Infrarot-Lichtquelle oder als eine Laserdiode ausgeformt sein.

Die Gerätetür kann zudem ein mindestens teilweise verformbares Material aufweisen. Vorteilhafterweise kann dadurch ein Eindrücken der Gerätetür für eine Abstandsmessung ermöglicht werden.

Gemäß einer Ausführungsform kann das Haushaltgerät eine Blende aufweisen, die zwischen der Sensoreinheit und der Gerätetür angeordnet sein kann. Durch die Blende kann vorteilhafterweise der Erfassungssensor beispielsweise vor Schmutzpartikeln geschützt werden. Weiterhin kann durch die Blende eine Gerätefront für den Nutzer ansprechend gestaltet werden.

Weiterhin kann der Innenraum des Gerätekorpus in einen ersten Aufnahmebereich und mindestens einen weiteren Aufnahmebereich unterteilt sein, wobei die Gerätetür in eine erste Zone und mindestens eine weitere Zone unterteilt sein kann. Die Sensoreinheit kann ausgebildet sein, um die Benutzerinteraktion in der ersten Zone auf der Außenfläche der Gerätetür erfassen zu können, um die Gerätefunktion des Haushaltgerätes im ersten Aufnahmebereich aktivieren und zusätzlich oder alternativ deaktivieren zu können. Ferner kann die Sensoreinheit ausgebildet sein, um mindestens eine weitere Benutzerinteraktion in der weiteren Zone auf der Außenfläche der Gerätetür erfassen zu können, um die Gerätefunktion des Haushaltgerätes im weiteren Aufnahmebereich aktivieren und zusätzlich oder alternativ deaktivieren zu können. Vorteilhafterweise können die unterschiedlichen Aufnahmebereiche dadurch individuell betätigt, beispielsweise beleuchtet werden. Anders ausgedrückt können also beliebige Bereiche der Glastür zur Benutzerinteraktion genutzt werden, die optisch nicht verbaut sind. Beispielsweise kann das Haushaltgerät in drei Abschnitte eingeteilt werden, in denen die Gerätefunktion, wie beispielsweise eine Innenraumbeleuchtung getrennt geschaltet werden kann. Der Nutzer kann beispielsweise eine der Zonen der Gerätetür auf der Glasfront berühren und so die Gerätefunktion aktivieren oder deaktivieren. Die Berührung kann vorteilhafterweise wird mittels der Sensoreinheit erkannt werden.

Gemäß einer Ausführungsform kann die erste Zone in einer Ebene mit dem ersten Aufnahmebereich und die zweite Zone in einer Ebene mit dem weiteren Aufnahmebereich angeordnet sein. Das bedeutet, dass beispielsweise eine Beleuchtung eines Aufnahmebereichs mit der entsprechenden Zone der Gerätetür verknüpft sein kann.

Es wird ferner ein Verfahren zum Aktivieren und zusätzlich oder alternativ zum Deaktivieren einer Gerätefunktion eines Haushaltgerätes in einer zuvor genannten Variante vorgestellt, wobei das Verfahren einen Schritt des Einlesens eines Interaktionssignals über eine Schnittstelle zu der Sensoreinheit, wobei das Interaktionssignal eine Benutzerinteraktion eines Nutzers auf der Außenfläche der Gerätetür repräsentiert, und einen Schritt des Ausgebens eines Ansteuersignals zum Ansteuern mindestens einer Gerätekomponente des Haushaltgerätes umfasst, um die Gerätefunktion ansprechend auf das Interaktionssignal zu aktivieren und zusätzlich oder alternativ zu deaktivieren.

Das Verfahren kann beispielsweise von einem Nutzer ausgelöst werden, indem er die Außenfläche der Gerätetür berührt. Die Gerätefunktion kann vorteilhafterweise eine Beleuchtung des Innenraums betreffen.

Der hier vorgestellte Ansatz schafft ferner eine Steuereinheit, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Vorrichtung kann die der Erfindung zugrunde liegende Aufgabe schnell und effizient gelöst werden.

Die Steuereinheit kann ausgebildet sein, um Eingangssignale einzulesen und unter Verwendung der Eingangssignale Ausgangssignale zu bestimmen und bereitzustellen. Ein Eingangssignal kann beispielsweise ein über eine Eingangsschnittstelle der Steuereinheit einlesbares Sensorsignal darstellen. Ein Ausgangssignal kann ein Steuersignal oder ein Datensignal darstellen, das an einer Ausgangsschnittstelle der Steuereinheit bereitgestellt werden kann. Die Steuereinheit kann ausgebildet sein, um die Ausgangssignale unter Verwendung einer in Hardware oder Software umgesetzten Verarbeitungsvorschrift zu bestimmen. Beispielsweise kann die Steuereinheit dazu eine Logikschaltung, einen integrierten Schaltkreis oder ein Softwaremodul umfassen und beispielsweise als ein diskretes Bauelement realisiert sein oder von einem diskreten Bauelement umfasst sein.

Von Vorteil ist auch ein Computer-Programmprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann. Wird das Programmprodukt oder Programm auf einem Computer oder einer Steuereinheit ausgeführt, so kann das Programmprodukt oder Programm zur Durchführung, Umsetzung und/oder Ansteuerung der Schritte des Verfahrens nach einer der hier beschriebenen Ausführungsformen verwendet werden.

Auch wenn der beschriebene Ansatz anhand eines Haushaltgeräts beschrieben wird, kann der hier beschriebene Ansatz entsprechend im Zusammenhang mit einem gewerblichen oder professionellen Gerät, beispielsweise einem medizinischen Gerät, wie einem Reinigungs- oder Desinfektionsgerät, einem Kleinsterilisator, einem Großraumdesinfektor oder einer Container-Waschanlage eingesetzt werden.

Ein Ausführungsbeispiel der Erfindung ist in den Zeichnungen rein schematisch dargestellt und wird nachfolgend näher beschrieben. Es zeigt
- Figur 1: eine schematische Darstellung eines Ausführungsbeispiels eines Haushaltgerätes;
- Figur 2: eine schematische Schnittdarstellung eines Ausführungsbeispiels eines Haushaltgerätes;
- Figur 3: eine vergrößerte schematische Darstellung eines Ausführungsbeispiels einer Sensoreinheit eines Haushaltgerätes;
- Figur 4: eine schematische Darstellung eines Ausführungsbeispiels einer Sensoreinheit eines Haushaltgerätes;
- Figur 5: eine schematische Darstellung eines Ausführungsbeispiels einer Sensoreinheit eines Haushaltgerätes;
- Figur 6: ein Ablaufdiagramm eines Ausführungsbeispiels eines Verfahrens zum Aktivieren und/oder Deaktivieren einer Gerätefunktion eines Haushaltgerätes; und
- Figur 7: ein Blockschaltbild eines Ausführungsbeispiels einer Steuereinheit.

Zur Erläuterung des Hintergrunds soll vorab erwähnt werden, dass es Hausgeräte gibt, deren Gerätefront kaum Möglichkeiten für einen Einbau einer Bedienoberfläche bieten und hinter denen keine Bedienelektronik, oder Sensorik befestigt werden kann. Ein Beispiel dafür ist ein vitrinenähnlicher Schrank mit einer Glastür als Gerätefront.

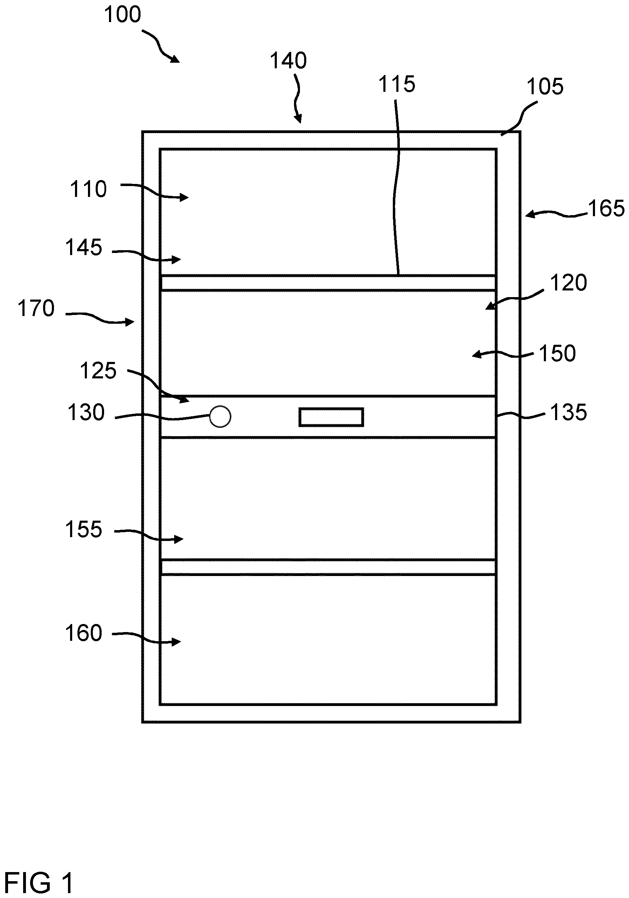

Figur 1 zeigt eine schematische Darstellung eines Ausführungsbeispiels eines Haushaltgerätes 100. Das Haushaltgerät 100 ist hierbei beispielsweise als ein Weinschrank realisiert. Alternativ kann es sich bei dem Haushaltgerät 100 jedoch auch um andere Geräte handeln, die beispielsweise vitrinenähnlich realisiert sind oder mindestens eine transparente Front aufweisen.

Das Haushaltgerät 100 weist einen Gerätekorpus 105 auf, der einen Innenraum 110 zum Aufnehmen von Aufbewahrungsgut ausformt. Das Aufbewahrungsgut ist beispielsweise in Form von Weinflaschen realisierbar. Das Haushaltgerät 100 als Weinschrank ist beispielsweise ausgebildet, um eine für den Wein vorteilhafte Temperatur im Innenraum 110 zu halten. Optional weist das Haushaltgerät 100 im Innenraum 110 mindestens einen, aber insbesondere eine Mehrzahl von Einlegeböden 115 auf. Das Haushaltgerät 100 weist weiterhin eine zumindest teilweise transparente Gerätetür 120 zum Öffnen und Verschließen des Innenraums 110, wobei die Gerätetür 120 eine dem Inneren des Gerätekorpus 105 zugewandte Innenfläche und eine der Innenfläche abgewandte Außenfläche aufweist, und eine Sensoreinheit 125 mit mindestens einem auf einen transparenten Abschnitt der Innenfläche der Gerätetür 120 gerichteten Erfassungssensor 130 zum Erfassen einer Benutzerinteraktion eines Nutzers auf der Außenfläche der Gerätetür 120, um eine Gerätefunktion des Haushaltgerätes 100 zu aktivieren und/oder zu deaktivieren. Die Sensoreinheit 125 ist dabei im Innenraum 110 angeordnet. Genauer gesagt ist die Sensoreinheit 125 mittig im Innenraum 110 angeordnet und beispielsweise in einen der Einlegeböden 115 integriert. Dadurch werden beispielsweise Kabel zur elektrischen Versorgung der Sensoreinheit 125 versteckt und für einen Nutzer unsichtbar gemacht. Gemäß diesem Ausführungsbeispiel ist der Erfassungssensor 130 ausgebildet, um die Benutzerinteraktion, wie beispielsweise ein Drücken oder ein Berühren der Gerätetür 120 zu erfassen. Dies erfolgt beispielsweise unter Verwendung einer Reflektionsmessung und/oder unter Verwendung einer optischen Abstandsmessung. Bei der Reflektionsmessung wird also an der Gerätetür reflektiertes Licht erfasst. Dies bedeutet, dass der Erfassungssensor 130 als optischer Sensor ausgeformt ist und zusätzlich oder alternativ eine Lichtquelle aufweist, wie beispielsweise eine lichtemittierende Diode (LED), eine Infrarotlichtquelle oder eine Laserdiode.

Da die Gerätetür 120 transparent ausgeformt ist, wird in einem Ruhezustand nur ein kleiner Teil von ausgesandtem Licht an der Innenfläche der Gerätetür 120 reflektiert. Berührt der Nutzer die Gerätetür, findet an dem Ort der Berührung eine stärkere Lichtreflektion statt. Eine Lichtintensität des reflektierten Lichts ist beispielsweise durch den Erfassungssensor 130 messbar, sodass dies beispielsweise bei Überschreiten eines vorgegebenen Schwellenwerts einen Rückschluss auf die Benutzerinteraktion zulässt. Für die optische Abstandsmessung wird beispielsweise ein Time-of-Flight-Sensor und/oder ein Interferenzverfahren verwendet, sodass auch Abstandsveränderungen im Mikrometerbereich erfasst werden können.

Ferner weist das Haushaltgerät 100 beispielsweise eine Blende 135 auf, die zwischen der Sensoreinheit 125 und der Gerätetür 120 angeordnet ist. Die Blende 135 ist beispielsweise derart angeordnet, dass sie elektrische Komponenten der Sensoreinheit 125 vor äußeren Einflüssen schützt und zugleich eine Frontseite 140 des Haushaltgerätes 100 verschönert.

Gemäß diesem Ausführungsbeispiel ist der Innenraum 110 des Gerätekorpus 105 in einen ersten Aufnahmebereich 145 und in mindestens einen weiteren Aufnahmebereich 150 unterteilt und weist optional zusätzliche Aufnahmebereiche 155, 160 auf. Eine Anzahl der Aufnahmebereiche ist demnach beispielsweise variabel. Die Gerätetür 120 ist ferner gemäß diesem Ausführungsbeispiel in eine erste Zone 165 und in mindestens eine weitere Zone 170 unterteilt. Hierbei ist die Sensoreinheit 125 beispielsweise ausgebildet ist, um die Benutzerinteraktion in der ersten Zone 165 auf der Außenfläche der Gerätetür 120 zu erfassen, um die Gerätefunktion des Haushaltgerätes 100 im ersten Aufnahmebereich 145 zu aktivieren und/oder zu deaktivieren. Weiterhin ist die Sensoreinheit 125 ausgebildet, um mindestens eine weitere Benutzerinteraktion in der weiteren Zone 170 auf der Außenfläche der Gerätetür 120 zu erfassen, um die Gerätefunktion des Haushaltgerätes 100 im weiteren Aufnahmebereich 150 zu aktivieren und/oder zu deaktivieren. Dies ist lediglich optional auch auf die zusätzlichen Aufnahmebereiche 155, 160 erweiterbar. Gemäß diesem Ausführungsbeispiel ist die erste Zone 165 in einer Ebene mit dem ersten Aufnahmebereich 145 angeordnet und die zweite Zone 170 in einer Ebene mit dem zweiten Aufnahmebereich 150.

In einer Ausführungsvariante weist das Haushaltgerät 100 beispielsweise drei Aufnahmebereiche auf, die sich in einem betriebsbereiten Zustand des Haushaltgerätes 100 in einen oberen, einen mittleren und einen unteren Aufnahmebereich unterscheiden lassen. Je nachdem, in welcher Zone der Gerätetür der Nutzer die Gerätetür berührt, wird entsprechend dem zuvor Beschriebenen der der berührten Zone zugeordnete Aufnahmebereich aktiviert oder deaktiviert, beispielsweise die Beleuchtung. Lediglich optional weist die Sensoreinheit 125 weitere Erfassungssensoren auf, sodass jedem der Aufnahmebereiche und somit auch jeder der Zonen ein eigener Erfassungssensor zugeordnet ist.

In anderen Worten ausgedrückt wird eine optische Sensierung von Touchgesten über Abstand ermöglicht. Dazu wird gemäß diesem Ausführungsbeispiel ein System zur optischen Sensierung einer Benutzerinteraktion auf einer Geräteoberfläche genutzt. Die optische Sensierung erfolgt gemäß diesem Ausführungsbeispiel unter Verwendung der Sensoreinheit 125, die beispielsweise auch als Sensormodul bezeichnet wird, berührungslos. Das bedeutet, dass die Sensoreinheit 125 mit einem Abstand zu der Gerätetür 120 hinter einer geeigneten Blende 135 angeordnet ist und genutzt wird.

Gemäß diesem Ausführungsbeispiel ist das Haushaltgerät 100 als ein Weinschrank mit einer Glastür realisiert. Im Folgenden wird ein Beispielszenario für das Haushaltgerät 100 als Weinschrank beschrieben:
Der Nutzer möchte das Licht im Weinschrank einschalten, ohne diesen öffnen zu müssen, um den Inhalt des Weinschrankes einsehen zu können. Der Nutzer berührt die Glasfront und schaltet so mit einer Touchgeste, das bedeutet mittels einer Berührung, das Licht ein. Die Berührung der Glasoberfläche wird mit der auch als Sensorik bezeichneten Sensoreinheit 125 detektiert, die sich im Bedienpanel und somit hinter der Blende 135 im Innenraum 110 des Weinschrankes 100 befindet. Das Bedienpanel ist hierbei mit einem Abstand von mehreren Zentimetern im mittleren Bereich des Weinschrankes angeordnet. Das Bedienpanel umfasst die Blende 135, hinter der der Erfassungssensor 130 als optischer Sensor verbaut ist. Dieser optische Sensor 130 ist auf die Rückseite der Glastür ausgerichtet und detektiert einen Bereich, der vom Nutzer zur Benutzerinteraktion verwendet wird. Wenn der Nutzer diesen Bereich durch eine Touchgeste berührt, wird das Licht des optischen Sensors 130 auf zwei mögliche Arten beeinflusst. Entweder verändert die Hand des Nutzers durch die Berührung des Glases die Reflektivität und beeinflusst so die Intensität des reflektierten Signals, oder die Touchgeste drückt das Glas soweit ein, dass dies durch den optischen Sensor detektiert werden kann. Letzteres erfolgt beispielsweise aufgrund einer optischen Abstandsmessung optional mittels Time-of-Flight oder über ein Interferenzverfahren, bei dem die Abstandsänderung ebenfalls einen Einfluss auf das detektierte Signal hat. Diese Abstandsänderungen liegen mit heutigen Messmethoden beispielsweise im Mikrometerbereich.

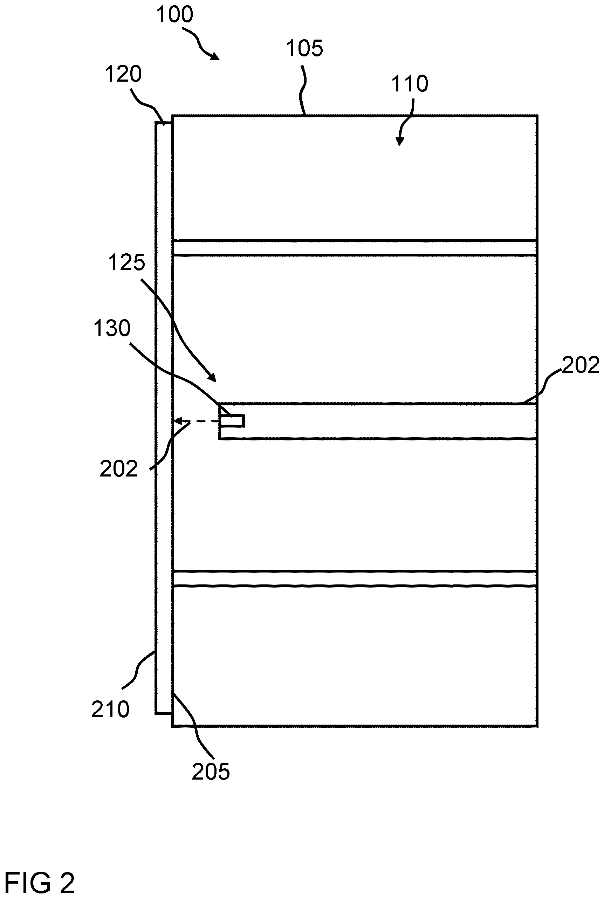

Figur 2 zeigt eine schematische Schnittdarstellung eines Ausführungsbeispiels eines Haushaltgerätes 100, wie es beispielsweise in Figur 1 beschrieben wurde. Gemäß diesem Ausführungsbeispiel ist die Sensoreinheit 125, bzw. das gesamte Bedienpanel 200 beabstandet zu der Gerätetür 120, insbesondere zu einer Innenfläche 200 der Gerätetür 120 angeordnet. Der Abstand 202, der gemäß diesem Ausführungsbeispiel symbolisch mittels eines Pfeils dargestellt ist, beträgt beispielsweise zwischen 3 und 10 cm. Der Pfeil kann zudem eine Blickrichtung des Erfassungssensors 130 und somit einen Erfassungsbereich repräsentieren. An einer der Innenfläche 205 abgewandten Seite der Gerätetür 120 weist dieselbe die in Figur 1 erwähnte Außenfläche 210 auf, an der die Benutzerinteraktion durch den Nutzer erfolgt.

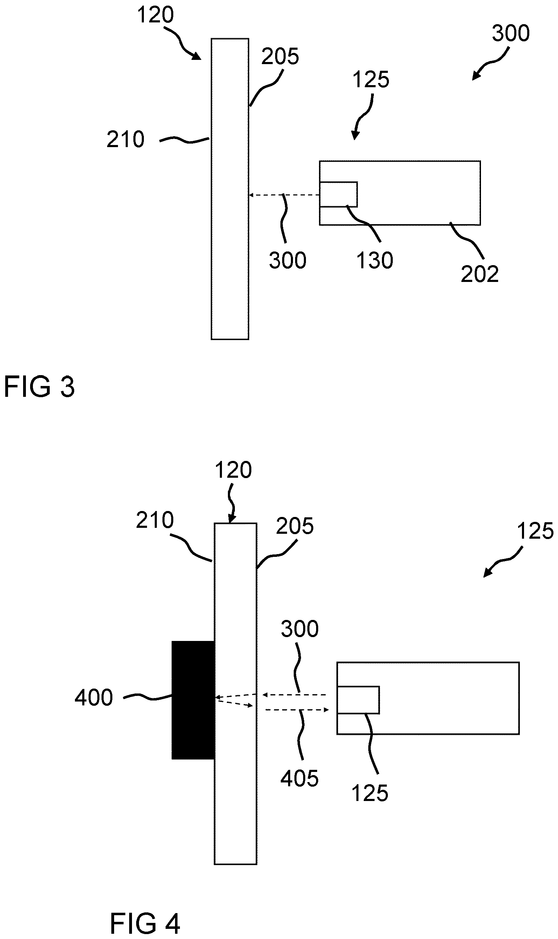

Figur 3 zeigt eine vergrößerte schematische Darstellung eines Ausführungsbeispiels einer Sensoreinheit 125 eines Haushaltgerätes, wie sie beispielsweise in mindestens einer der Figuren 1 bis 2 beschrieben oder erwähnt wurde. Das bedeutet, dass hierbei ein Ausschnitt 300 des Haushaltgerätes in einem Ruhezustand dargestellt ist. Wie auch in Figur 2 ist der Erfassungssensor 130 gemäß diesem Ausführungsbeispiel in das Bedienpanel 202 integriert und ist in Richtung der Innenfläche 205 ausgerichtet. Beispielsweise sendet der Erfassungssensor 130 Licht 300 in Richtung der Innenfläche 205 aus. Die Sensoreinheit 125 ist dabei von der Gerätetür 120 beabstandet angeordnet.

Figur 4 zeigt eine schematische Darstellung eines Ausführungsbeispiels einer Sensoreinheit 125 eines Haushaltgerätes, wie sie beispielsweise in mindestens einer der Figuren 1 bis 3 beschrieben wurde. Gemäß diesem Ausführungsbeispiel ist jedoch ein Betriebszustand dargestellt. Das bedeutet, dass ein Objekt 400 die Außenfläche 210 kontaktiert und dadurch die Benutzerinteraktion getätigt wird. Dieses Objekt 400 ist beispielsweise ein Finger eines Nutzers. Wie auch in Figur 3 sendet der Erfassungssensor 130 beispielsweise Licht 300 zu der Innenfläche 205 der Gerätetür 120, an der das Licht 300 bei einem Eintritt in die Gerätetür 120 gebrochen wird und an der Außenfläche 210 in Richtung des Erfassungssensors 130 an der Stelle reflektiert wird, wo das Objekt 400 die Außenfläche 210 berührt. Das reflektierte Licht 405 wird bei dem Austritt aus der Gerätetür 120 erneut gebrochen.

Das bedeutet in anderen Worten ausgedrückt, dass der optische Sensor 130 auf die Rückseite der Glastür 120 schaut. Unter Verwendung von Licht 300 wird erkannt, ob sich an der Außenfläche 210 der Tür ein Objekt 400, beispielsweise eine Hand, befindet.

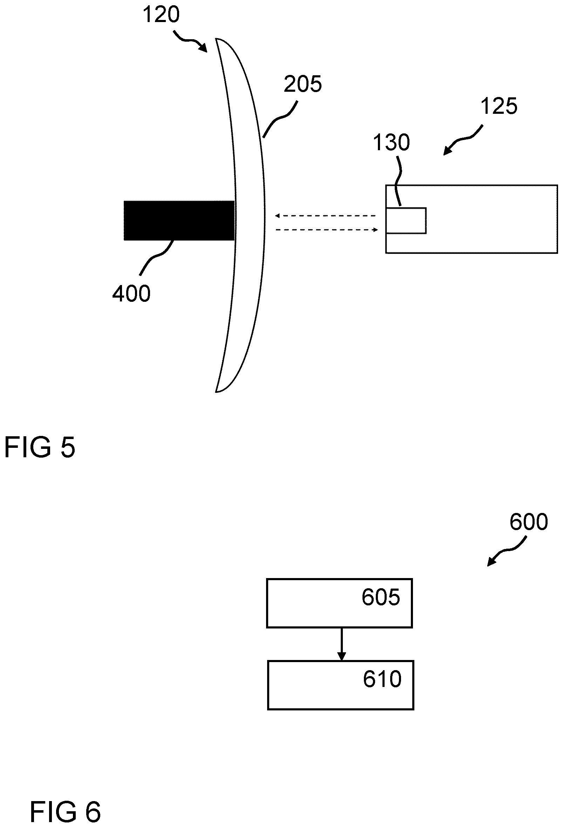

Figur 5 zeigt eine schematische Darstellung eines Ausführungsbeispiels einer Sensoreinheit 125 eines Haushaltgerätes, die beispielsweise der in einer der Figuren 1 bis 4 beschriebenen Sensoreinheit ähnelt. Gemäß diesem Ausführungsbeispiel weist die Gerätetür 120 auf Höhe der Sensoreinheit 125 ein mindestens teilweise verformbares Material auf, sodass die Sensoreinheit 125 eine Abstandsmessung durchführen kann. Beispielsweise erfolgt die Benutzerinteraktion unter Verwendung von Druck, sodass die Gerätetür 120 verformt wird. Die Sensoreinheit 125 ist dabei ausgebildet, um einen Abstand zwischen der Sensoreinheit 125 und der Innenfläche 205 vor und nach dem Eindrücken zu messen. Eine daraus folgende Distanzänderung ermöglicht einen Rückschluss auf die Benutzerinteraktion.

Figur 6 zeigt ein Ablaufdiagramm eines Ausführungsbeispiels eines Verfahrens 600 zum Aktivieren und/oder Deaktivieren einer Gerätefunktion eines Haushaltgerätes, wie es beispielsweise in mindestens einer der Figuren 1 bis 5 beschrieben oder erwähnt wurde. Das Verfahren 600 umfasst dabei einen Schritt 605 Einlesens eines Interaktionssignals über eine Schnittstelle zu der Sensoreinheit, wobei das Interaktionssignal eine Benutzerinteraktion eines Nutzers auf der Außenfläche der Gerätetür repräsentiert, und einen Schritt 610 des Ausgebens eines Ansteuersignals zum Ansteuern mindestens einer Gerätekomponente des Haushaltgerätes, um die Gerätefunktion ansprechend auf das Interaktionssignal zu aktivieren und/oder zu deaktivieren.

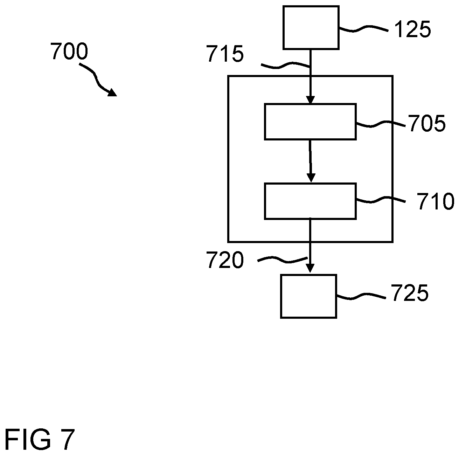

Figur 7 zeigt ein Blockschaltbild eines Ausführungsbeispiels einer Steuereinheit 700 für ein Haushaltgerät, wie es beispielsweise in mindestens einer der Figuren 1 bis 5 beschrieben oder erwähnt wurde. Die Steuereinheit 700 ist beispielsweise als Teil des Haushaltgerätes realisiert oder realisierbar und ist ausgebildet, um ein Verfahren zum Aktivieren und/oder Deaktivieren einer Gerätefunktion eines Haushaltgerätes anzusteuern und/oder durchzuführen, wie es beispielsweise in Figur 6 beschrieben wurde. Dazu weist die Steuereinheit 700 eine Einleseeinheit 705 und eine Ausgabeeinheit 710 auf. Die Einleseeinheit 705 ist ausgebildet, um ein Interaktionssignal 715 über eine Schnittstelle zu der Sensoreinheit 125 einzulesen, wobei das Interaktionssignal 715 eine Benutzerinteraktion eines Nutzers auf der Außenfläche der Gerätetür repräsentiert. Die Ausgabeeinheit 710 ist ausgebildet, um ein Ansteuersignal 720 zum Ansteuern mindestens einer Gerätekomponente 725 des Haushaltgerätes anzusteuern, um die Gerätefunktion ansprechend auf das Interaktionssignal zu aktivieren und/oder zu deaktivieren. Beispielsweise ist die Gerätekomponente 725 als eine Lichtquelle des Haushaltgerätes ausgeführt.

## Patentansprüche

1. Haushaltgerät (100), das die folgenden Merkmale aufweist:
- einen Gerätekorpus (105), der einen Innenraum (110) zum Aufnehmen von Aufbewahrungsgut ausformt;
- eine zumindest teilweise transparente Gerätetür (120) zum Öffnen und Verschließen des Innenraums (110), wobei die Gerätetür (120) eine dem Inneren des Gerätekorpus (105) zugewandte Innenfläche (205) und eine der Innenfläche (205) abgewandte Außenfläche (210) aufweist; und
- eine Sensoreinheit (125) mit mindestens einem auf einen transparenten Abschnitt der Innenfläche (205) der Gerätetür (120) gerichteten Erfassungssensor (130) zum Erfassen einer Benutzerinteraktion eines Nutzers auf der Außenfläche (210) der Gerätetür (120), um eine Gerätefunktion des Haushaltgerätes (100) zu aktivieren und/oder zu deaktivieren, wobei die Sensoreinheit (125) im Innenraum (110) angeordnet ist.

2. Haushaltgerät (100) gemäß Anspruch 1, wobei die Sensoreinheit (125) beabstandet zu der Innenfläche (110) der Gerätetür (120) angeordnet ist, insbesondere mit einem Abstand von 3 bis 10cm.

3. Haushaltgerät (100) gemäß einem der vorangegangenen Ansprüche, wobei der Erfassungssensor (130) ausgebildet ist, um die Benutzerinteraktion unter Verwendung einer Reflektionsmessung und/oder unter Verwendung einer optischen Abstandsmessung zu erfassen.

4. Haushaltgerät (100) gemäß einem der vorangegangenen Ansprüche, wobei der Erfassungssensor (130) als ein optischer Sensor ausgeformt ist und/oder zumindest eine Lichtquelle aufweist.

5. Haushaltgerät (100) gemäß einem der vorangegangenen Ansprüche, wobei die Gerätetür (120) ein mindestens teilweise verformbares Material aufweist.

6. Haushaltgerät (100) gemäß einem der vorangegangenen Ansprüche, mit einer Blende (135), die zwischen der Sensoreinheit (125) und der Gerätetür (120) angeordnet ist.

7. Haushaltgerät (100) gemäß einem der vorangegangenen Ansprüche, wobei der Innenraum (110) des Gerätekorpus (105) in einen ersten Aufnahmebereich (145) und mindestens einen weiteren Aufnahmebereich (150) unterteilt ist, wobei die Gerätetür (120) in eine erste Zone (165) und mindestens eine weitere Zone (170) unterteilt ist, wobei die Sensoreinheit (125) ausgebildet ist, um die Benutzerinteraktion in der ersten Zone (165) auf der Außenfläche (210) der Gerätetür (120) zu erfassen, um die Gerätefunktion des Haushaltgerätes (100) im ersten Aufnahmebereich (145) zu aktivieren und/oder zu deaktivieren, und wobei die Sensoreinheit (125) ausgebildet ist, um mindestens eine weitere Benutzerinteraktion in der weiteren Zone (170) auf der Außenfläche (210) der Gerätetür (120) zu erfassen, um die Gerätefunktion des Haushaltgerätes (100) im weiteren Aufnahmebereich (150) zu aktivieren und/oder zu deaktivieren.

8. Haushaltgerät (100) gemäß Anspruch 7, wobei die erste Zone (165) in einer Ebene mit dem ersten Aufnahmebereich (145) angeordnet ist, und wobei die weitere Zone (170) in einer Ebene mit dem weiteren Aufnahmebereich (150) angeordnet ist.

9. Verfahren (600) zum Aktivieren und/oder Deaktivieren einer Gerätefunktion eines Haushaltgerätes (100) gemäß einem der vorangegangenen Ansprüche, wobei das Verfahren (600) die folgenden Schritte umfasst:
- Einlesen (605) eines Interaktionssignals (715) über eine Schnittstelle zu der Sensoreinheit (125), wobei das Interaktionssignal (715) eine Benutzerinteraktion eines Nutzers auf der Außenfläche (210) der Gerätetür (120) repräsentiert; und
- Ausgeben (610) eines Ansteuersignals (720) zum Ansteuern mindestens einer Gerätekomponente (725) des Haushaltgerätes (100), um die Gerätefunktion ansprechend auf das Interaktionssignal (715) zu aktivieren und/oder zu deaktivieren.

10. Steuereinheit (700) für ein Haushaltgerät (100) gemäß einem der Ansprüche 1 bis 8, die ausgebildet ist, um die Schritte (605, 610) des Verfahrens (600) gemäß Anspruch 9 in entsprechenden Einheiten (705, 710) auszuführen und/oder anzusteuern.

11. Computer-Programmprodukt mit Programmcode zur Durchführung des Verfahrens (600) nach Anspruch 9, wenn das Computer-Programmprodukt auf einer Steuereinheit (700) gemäß Anspruch 10 ausgeführt wird.
